Europäisches Patentamt

European Patent Office

Office européen des brevets

(19)

(11) **EP 0 513 330 B1**

(12) **FASCICULE DE BREVET EUROPEEN**

(45) Date de publication et mention
de la délivrance du brevet:
**11.09.1996 Bulletin 1996/37**

(21) Numéro de dépôt: **92901728.3**

(22) Date de dépôt: **03.12.1991**

(51) Int Cl.6: **H03K 5/05**, G09G 3/36

(86) Numéro de dépôt international:
**PCT/FR91/00962**

(87) Numéro de publication internationale:
**WO 92/09187 (11.06.1992 Gazette 1992/13)**

(54) **CIRCUIT DE GENERATION D'IMPULSIONS DE LARGEUR VARIABLE POUR UN DRIVER D'AFFICHAGE A CRISTAUX LIQUIDES**

**IMPULSERZEUGUNGSSCHALTUNG MIT VERÄNDERLICHER IMPULSBREITE FÜR EINEN TREIBER EINER FLÜSSIGKRISTALLANZEIGE**

**CIRCUIT FOR GENERATING VARIABLE WIDTH PULSES FOR A LIQUID CRISTAL DISPLAY DRIVER**

(84) Etats contractants désignés:
**DE FR GB NL**

(30) Priorité: **03.12.1990 US 620684**

(43) Date de publication de la demande:
**19.11.1992 Bulletin 1992/47**

(73) Titulaire: **THOMSON S.A.**
**92800 Puteaux (FR)**

(72) Inventeurs:
• **BRIGGS, George, Roland**
**F-92045 Paris-La Défense Cédex 67 (FR)**
• **STEWART, Roger, Green**
**F-92045 Paris-La Défense Cédex 67 (FR)**

(74) Mandataire: **Ruellan-Lemonnier, Brigitte et al**
**THOMSON Multimedia,**
**9 Place des Vosges**
**La Défense 5**
**92050 Paris La Défense (FR)**

(56) Documents cités:
EP-A- 0 432 798          US-A- 4 742 346
US-A- 4 833 464

## Description

Cette invention concerne les composants d'un circuit permettant de générer des impulsions de contrôle d'une largeur proportionnelle, par exemple, à un nombre binaire appliqué à ces composants.

Le brevet américain n° 4,742,346 de Gillette présente un dispositif d'affichage à cristaux liquides (LCD - Liquid Crystal Display) incorporant un circuit de commande, intégré aux éléments LCD sur un substrat ordinaire. Plusieurs circuits de compteurs programmables se trouvent au sein du circuit de commande. Les valeurs binaires représentant la luminosité de l'image sont appliquées à ces compteurs qui génèrent des impulsions d'une durée proportionnelle à ces valeurs. La durée des impulsions est ensuite convertie en variations de tension à appliquer à chaque élément d'affichage.

Supposons que les impulsions doivent représenter des valeurs binaires de huit bits, et que la plus longue équivaut environ à la partie active du temps de ligne horizontale du signal vidéo, qui est approximativement de 50 μs. Pour satisfaire ces contraintes, le compteur doit travailler à une vitesse d'environ 5 MHz, soit la réciproque de 50/256 μs. Par contre si, pour des raisons économiques, on fabrique le circuit du compteur en utilisant des transistors au silicium amorphe (aSi), cette vitesse tend à être trop élevée pour être supportée par ce type de montage. De plus, les compteurs programmables sont souvent relativement complexes et impliquent un nombre important d'éléments actifs.

La présente invention concerne des circuits pour la génération d'impulsions dont la durée est déterminée par des valeurs binaires reçues en entrée. De tels circuits sont généralement moins complexes que ceux mettant en oeuvre des compteurs programmables, et peuvent fonctionner à des fréquences d'horloge moins élevées que ces derniers.

Le système d'impulsions de largeur variable comprend plusieurs étages montés en cascade ; chaque étage traite un bit de la valeur binaire définissant la durée de l'impulsion de sortie. Chaque étage comprend un circuit de sortie qui est initialisé à un état prédéterminé au début de chaque impulsion. Deux signaux d'horloge øAn et øBn de phase différente sont appliqués à un circuit de porte qui laisse passer l'un ou l'autre (øAn ou øBn) de ces signaux d'horloge selon que le bit reçu est un 0 logique ou un 1 logique. Le circuit de porte est connecté au circuit de sortie de l'étage afin de remettre la tension de sortie à un état opposé audit état prédéterminé lors de la réception d'un signal d'horloge passé par le circuit de porte.

Les étages sont raccordés en cascade dans l'ordre du poids des bits : le bit de poids fort de la valeur binaire est traité en premier, le bit de poids faible est traité en dernier. Chaque étage successif est activé par le changement d'état du signal de sortie de l'étage précédent. Le signal de sortie de l'étage traitant le bit de poids faible constitue l'impulsion de largeur variable.

La présente invention sera mieux comprise et d'autres avantages apparaîtront à la lecture de la description qui va suivre, donnée à titre non limitatif, et grâce aux dessins annexés parmi lesquels:

-   la Figure 1 est un schéma synoptique simplifié d'un générateur d'impulsions de largeur variable selon l'invention.
-   la Figure 2 est un schéma logique d'un exemple de circuit qui pourrait servir pour les étages traitant un seul bit générant une largeur d'impulsion variable, tels que présentés sur la Figure 1.
-   la Figure 3 présente un chronogramme des tensions permettant de décrire le circuit de la Figure 2.
-   la Figure 4 est un schéma logique montrant la connexion de deux des étages à un seul bit présentés à la Figure 2.
-   la Figure 5 est un chronogramme illustrant le fonctionnement du circuit de la Figure 4.
-   la Figure 6 est un chronogramme illustrant les profils des signaux d'horloge requis dans le cas d'un système à quatre bits.
-   la Figure 7 est un schéma d'un autre étage à un seul bit générant une impulsion variable et faisant également appel à la présente invention.
-   les Figures 8, 9 et 10 représentent le chronogramme correspondant au fonctionnement du circuit de la Figure 7.
-   les Figures 11 et 12 représentent les signaux d'horloge pour un système à 3 bits intégrant des étages à un bit du type montré dans la Figure 7.

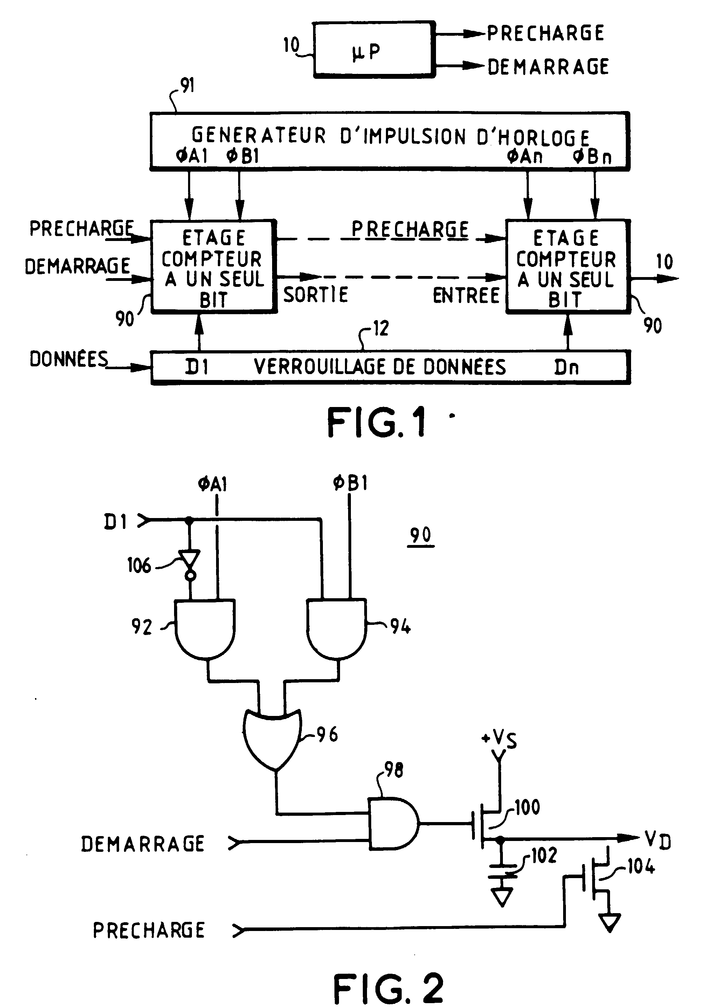

La Figure 1 présente, sous forme synoptique générale, le générateur d'impulsions de largeur variable qui comprend de nombreux étages 90 à un seul bit. Ces étages sont montées en cascade afin de traiter respectivement les bits de données binaires D1 à Dn (n étant un entier quelconque). Chacun des étages 90 à un seul bit est synchronisé par un couple différent de signaux d'horloge øAn, øBn, fournis par le générateur d'impulsion d'horloge 91.

Chaque étage de traitement connecté en cascade dispose d'une borne d'entrée de bits de données permettant d'appliquer un bit d'un mot porteur d'information sur la durée de l'impulsion. Chaque étage dispose également d'une borne de sortie, et d'une borne d'entrée pour l'impulsion de démarrage. La borne d'entrée pour l'impulsion de démarrage de chaque étage de traitement faisant partie de la cascade est reliée à la borne de sortie de l'étage précédent. Une impulsion de démarrage de source externe est appliquée à la borne d'entrée pour l'impulsion de démarrage de l'étage traitant le bit de données de poids fort. Les bits de données sont décodés dans l'ordre de leur poids, chaque étage étant successivement activé par une transition de sortie fournie par l'étage précédent (traitant le bit adjacent plus fort), cette transition correspondant à une transition prédéterminée de l'une des phases d'horloge øAn, øBn, appliquée à cet étage. L'étage qui traite le bit de poids faible fournit le signal de sortie, $V_D$, constituant une impulsion de durée qui représente soit la longueur du mot porteur d'information appliqué à tous les étages, soit la période de transition traînante de l'impulsion à largeur variable.

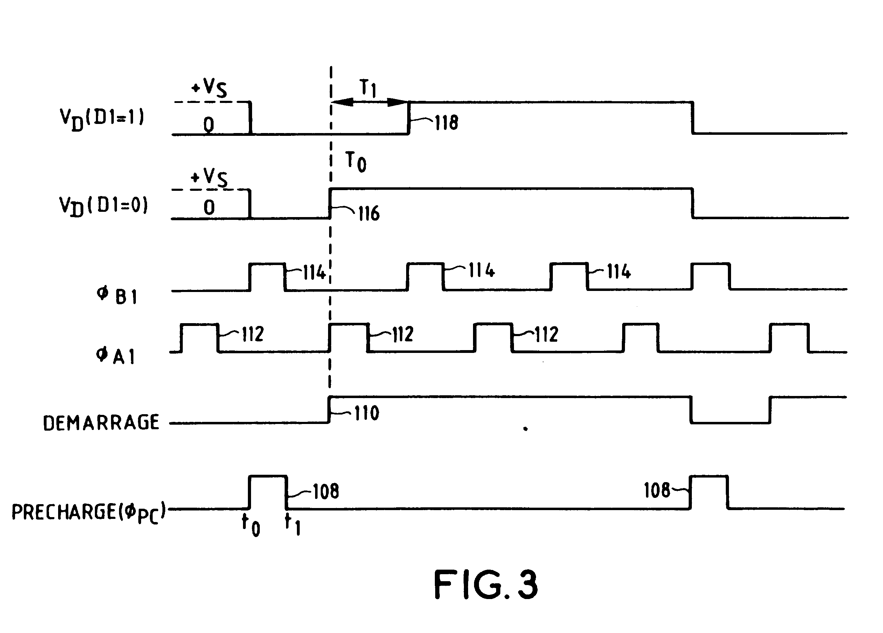

La Figure 2 représente la disposition du circuit logique d'un étage 90 à un seul bit, pour l'une des réalisations de l'invention. Comme indiqué, l'étage 90 à un seul bit comprend une paire de portes ET 92 et 94, une porte OU 96, une autre porte ET 98, un transistor de commutation 100, un condensateur 102, un second transistor de commutation 104 et un inverseur 106. Le fonctionnement de l'étage 90 à un seul bit sera décrit en se référant au chronogramme de la Figure 3. Au début d'un intervalle d'impulsion à largeur variable, une impulsion de précharge 108 est appliquée à la grille du transistor 104, ce qui met celui-ci en fonction pour la durée de l'impulsion 108 et décharge le condensateur de stockage 102 vers une source de potentiel de référence (la masse par exemple). Ceci initialise l'étage 90 à un seul bit. Si le bit de données binaire $D_1$ appliqué à l'étage à un seul bit est un zéro logique, il désactivera la porte ET 94 et activera la porte ET 92 via l'inverseur 106. Lorsqu'une impulsion 112 de l'horloge øA1 est appliquée à l'autre entrée de la porte ET 92, la sortie de la porte ET 92 passe au niveau haut, fournissant une entrée de niveau haut à la porte OU 96. A son tour, le signal de sortie de la porte OU 96 passera "en haut" et sera appliqué à une entrée de la porte ET 98. Si, simultanément, le signal de démarrage 110 est en haut, la porte ET 98 est activée et son signal de sortie passera du niveau bas ou niveau haut, dès l'application de l'entrée de niveau haut provenant de la porte OU 96. Le signal de sortie de niveau haut de la porte ET 98 est appliqué à la grille du transistor 100, préparant celui-ci à charger le condensateur 102 vers $+V_S$ et provoquant le passage de la tension de sortie $V_D$ au niveau haut, en même temps que les transitions positives de l'impulsion øA1 (voir le chronogramme de Fig.3, "$V_D$ (D1=0)").

Si $D_1$ est un niveau logique haut, c'est-à-dire un "1" binaire, l'inverseur 106 appliquera un "0" à une entrée de la porte ET 92, désactivant cette porte, et un "1" binaire est appliqué à une entrée de la porte ET 94, activant cette porte. Lorsque le signal d'impulsion d'horloge øB1 passe à l'état "1" binaire, le signal de sortie de la porte ET 94 passe de l'état "0" à l'état "1", ce signal étant couplé à une entrée de la porte ET 98 par l'intermédiaire de la porte OU 96. Comme la porte ET 98 est déjà activée via le signal de démarrage de niveau haut 110 relié à son autre borne d'entrée, le signal de sortie de la porte ET 98 passera de l'état "0" à l'état "1". Le stade "1" conditionne la fourniture par le transistor 100 d'une sortie logique de niveau haut $V_D$, coïncidant avec les transitions positives de l'impulsion d'horloge øB1 (voir le chronogramme de Fig.3, "$V_D$ (D1=1)").

Dans le système de la Figure 2, l'impulsion de sortie à largeur variable commence avec le front avant de l'impulsion de précharge et se termine avec la partie stable de l'impulsion d'horloge øA1 ou øB1. Ou bien, on peut considérer que le front avant de l'impulsion est défini par le front avant de l'impulsion d'horloge øA1 ou øB1, et que le front arrière est défini par le front de top de l'impulsion de précharge. Dans le cas d'applications de type balayage de LCD, la dernière définition de l'impulsion d'horloge variable est celle qui est applicable.

Le signal de sortie $V_D$ provenant d'un circuit 90 à un seul bit peut être appliqué à l'entrée de démarrage d'un étage suivant connecté en cascade à ce circuit, afin de déverrouiller ou d'activer l'étage 90 suivant dans la chaîne (cf. explications ci-après). Avant d'appliquer un nouveau bit de données à l'étage 90, on applique une autre impulsion de précharge 108 à la grille du transistor 104, afin de décharger le condensateur 102 et de réinitialiser l'étage 90 pour le prochain cycle du bit.

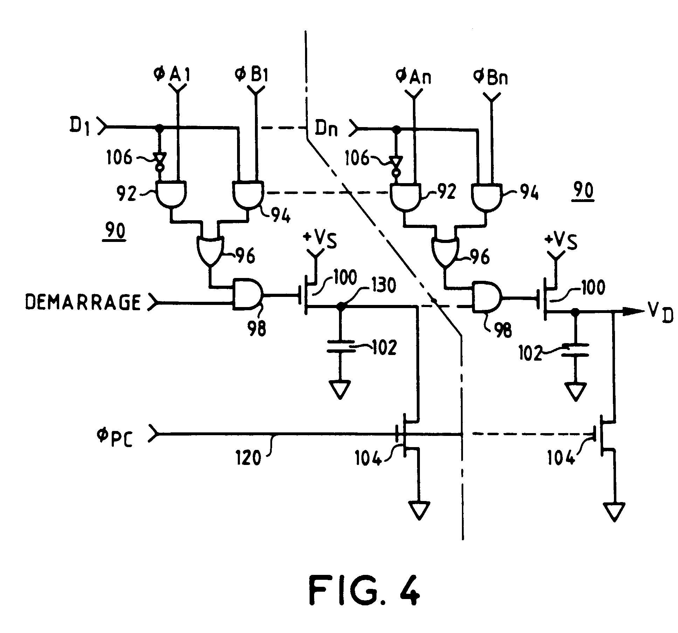

La Figure 4 montre la connexion de plusieurs étages à un seul bit présentés sur la Figure 2, en vue du traitement ou du décodage d'un signal binaire contenant "n" bits. Il faut noter que le signal de précharge 120 fait l'objet d'une connexion commune aux grilles des transistors 104 de chacun des étages 90 à un seul bit. Ainsi, tous les étages sont initialisés simultanément. Il faut également noter que deux impulsions d'horloge différentes sont nécessaires pour chaque étage 90, aucun étage ne recevant les mêmes impulsions d'horloge qu'un autre.

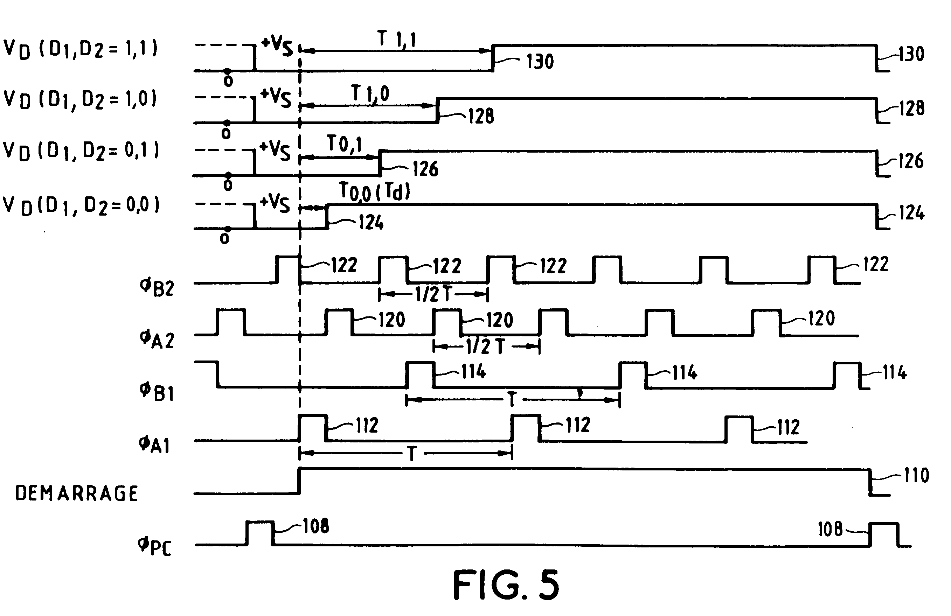

La Figure 5 représente le chronogramme pour l'exemple dans lequel deux étages à un seul bit sont connectés en cascade pour décoder un signal de données comprenant deux bits, D1 et D2. Dans la Figure 5, les signaux 108, 110, 112 et 114 sont très similaires à celles de la Figure 3 et sont associées pour le décodage du bit le plus significatif du signal de données binaire D1. Les profils des impulsions de synchronisation 120 et 122 sont associées respectivement avec les impulsions d'horloge øA2 et øB2, en vue de l'application au second étage 90, pour le décodage du bit de poids faible D2, dans cet exemple.

Le décodage du bit D1 est pratiquement identique au processus décrit précédemment pour l'étage à un seul bit de la Figure 2. Si D1 est "0", le noeud 130 du premier étage passera "en haut" en détectant le front avant de la première impulsion d'horloge øA1, représentée sur la Figure 5 par l'impulsion 112. Lorsque le noeud 130 passe "en haut", la porte ET 98 de l'étage comparateur 90 suivant est activé. Maintenant, si le bit de données $D_2$ est "0", le signal de sortie $V_D$ passera au niveau "haut" dès l'impulsion d'horloge suivante øA2, représentée par l'impulsion 120 sur la Figure 5. Le changement d'état du signal de sortie $V_D$ est indiqué par le profil 124. Ce changement se produit après une durée de temporisation $T_{0,0}$ suivant la transition positive du signal démarrage. En revanche, si le bit de données $D_2$ est "en haut" ou "1", le signal de sortie $V_D$ passera au niveau "haut" au moment de l'impulsion d'horloge suivante øB2, comme l'indique le profil 126 temporisé par $T_{0,1}$.

Si $D_1$ est "1", la porte ET 98 du second étage sera activé dès la première impulsion d'horloge øB1 (114) après la transition positive de l'impulsion de démarrage 110. Considérant que $D_2$ est un "0", la sortie $V_D$ passera en haut au moment de l'impulsion d'horloge øA2 suivante (120), comme l'indique le profil 128 temporisée par $T_{0,1}$. Cependant, si $D_2$ est un "1", la porte ET 92 du second étage sera inhibée et la porte ET 94 activée. Par conséquent, le transistor 100 de cet étage ne sera mis en fonction que lors de l'impulsion d'horloge øB2 suivante (122), la transition de tension de sortie étant représentée par le profil 130 temporisée par T1,1.

Les quatre variations de largeur d'impulsion possibles pour un signal à deux bits et pour les signaux d'horloge particuliers øAn, øBn, présentés par la Figure 5, sont illustrés par les profils 124 à 130. Toutefois, il faut noter que les points de transition peuvent être modifiés en changeant les points dans le temps où les transitions de synchronisation se produisent. Il faut également noter que, une fois qu'un étage produit une sortie logique de niveau haut (aux noeuds respectifs 130), la tension de sortie de cet étage restera inchangée quelles que soient les modifications d'état des données ou de l'horloge. La raison en est que l'état de sortie est stocké dans les condensateurs respectifs 102 qui ne peuvent être déchargés que par les transistors 104 à la suite des impulsions de précharge øpc. Enfin, il faut noter que la combinaison des transistors 100 et 104 avec le condensateur 102 sert la fonction de bascule de mise à 1 - mise à 0, øpc fournissant le signal de mise à 1 et la porte ET 98 fournissant le signal de mise à 0. Ainsi, pour des raisons pratiques, on peut remplacer les transistors 100 et 104 et le condensateur 102 par un élément bistable.

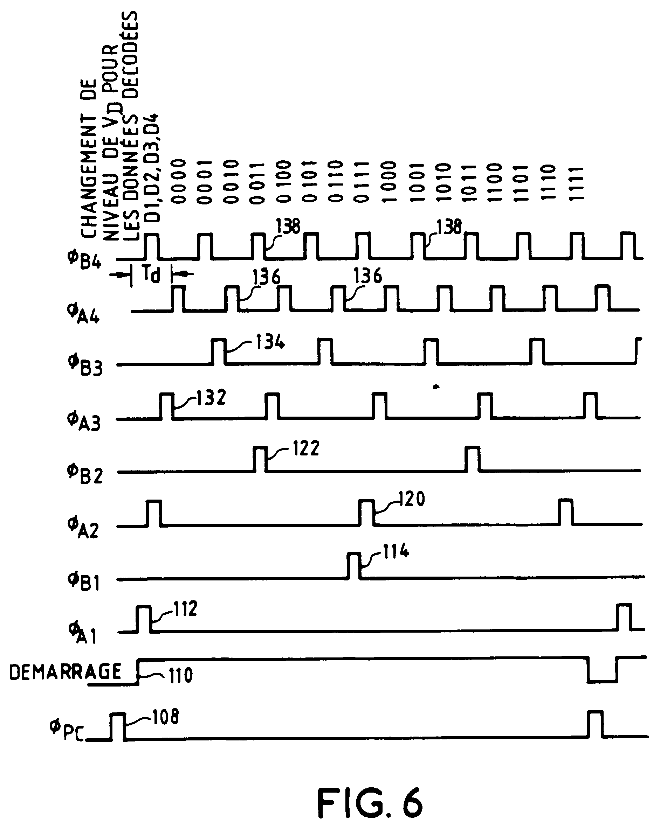

Les cycles d'horloge øA1 et øB1 présentés par la Figure 5 ont une durée T. Les cycles d'horloge øA2 et øB2, pour le deuxième étage 90 ou l'étage suivant dans le montage en cascade, ont une durée de T/2. Dans cet exemple, une telle réduction par un facteur d'un demi des durées des cycles d'horloge d'un étage par rapport à l'étage précédent, est applicable quel que soit le nombre d'étages 90 montés en cascade. Donc, si n = 4, pour le décodage d'un signal de données à quatre bits contenant les bits D1, D2, D3 et D4, le chronogramme correspond à la Figure 6. Comme l'indique ce diagramme, dans ce cas de décodage, il faut connecter en cascade quatre étages à un seul bit, avec quatre séries distinctes d'impulsions d'horloge, øA1 à øA4 et øB1 à øB4. Si l'on considère un signal de données binaire ayant une valeur à quatre bits de "0000", la tension de sortie $V_D$ ne quitte le niveau zéro Volt pour passer à un niveau supérieur qu'après une temporisation $T_d$, suivant la première impulsion d'horloge øA1 112 (cf. diagramme). Ceci correspond à $T_{0,0}$ dans la cascade à deux étages de la Figure 5. Le changement de niveau se produit principalement au début de la première impulsion d'horloge øA4 136 (cf. diagramme).

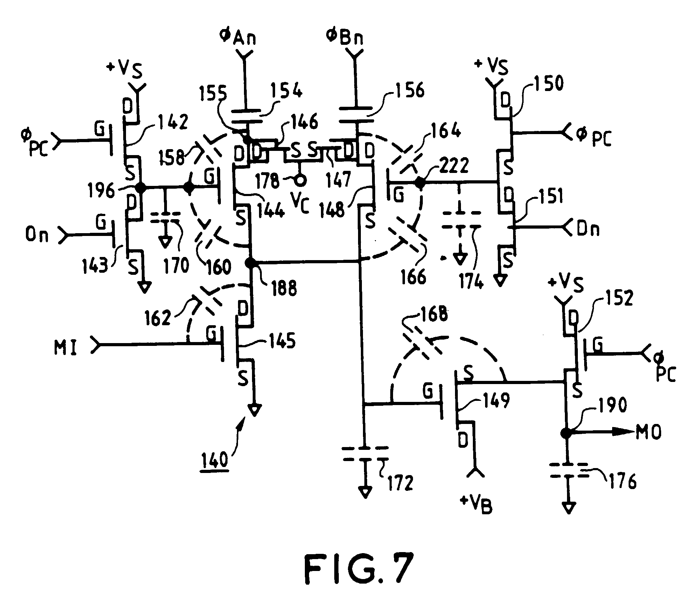

La Figure 7 présente une autre réalisation d'un circuit compteur à un seul bit, monté selon une logique dynamique ou impulsionnelle. Dans ce cas, on utilise une méthode d'amorçage pour obtenir des vitesses de commutation suffisamment rapides à partir des appareils à logique impulsionnelle lente, comme les appareils au silicium amorphe, ce qui permet d'utiliser le circuit 140 dans le système présenté sur la Figure 1, par exemple. Chaque étage compteur à un bit 140 peut être connecté en cascade pour le décodage de mots à plusieurs bits de données, comme indiqué précédemment pour les étages compteurs 90. Dans cet exemple, chaque étage compteur 140 comprend les transistors 142 à 152 de même type de conductivité, les condensateurs-survolteurs 154 et 156, les capacités intérieures 158, 160, 162, 164, 166 et 168 dessinées en pointillé, ainsi que les capacités de dispersion ou parasitaires 170, 172, 174 et 176, également dessinées en pointillé.

Soient tout d'abord les transistors 144 et 148 dont l'électrode de source est reliée au noeud 188, et soit le transistor 145 dont l'électrode de drain est couplée au noeud 188. L'électrode de source du transistor 145 est couplée au potentiel de la masse. Les électrodes de drain des transistors 144 et 148 sont respectivement connectées aux bus d'horloge øAn et øBn, via les condensateurs de liaison 154 et 156. Si les valeurs d'entrée logique appliquées aux grilles des transistors 144, 145 et 148 sont respectivement Dn, MI et $\overline{Dn}$, l'état logique du noeud 188 peut être représenté ainsi :

$$\text{NOEUD } 188 = (((Dn \cdot øAn) + (Dn \cdot øBn)) \cdot MI)$$

Le signal MI correspond à l'impulsion de démarrage, mais est inversé en polarité par rapport à l'impulsion de démarrage évoquée pour les Figures 2 et 3. Tant que l'impulsion de démarrage MI est au niveau haut, la sortie au noeud 188 sera au niveau bas. Inversement, si Mi est au niveau bas, et que, soit Dn est au niveau haut et øAn se produit, soit $\overline{Dn}$ est au niveau haut et øBn se produit, le noeud 188 présentera un "1" logique au moment de øBn ou de øAn. La tension de sortie au noeud 188 est stockée par la capacité de dispersion 172. Le signal d'entrée aux grilles des transistors 144 et 148 ainsi que le signal de sortie du noeud 188 sont fournis par les inverseurs dynamiques intermédiaires de type précharge. Dans la Figure 7, ces inverseurs intermédiaires comprennent les couples de transistors (142,143), (150,151) et (152,149) dont les chemins conducteurs source-drain sont connectés en série entre le potentiel relativement positif $+V_S$ et la tension d'alimentation relativement négative. Le signal de sortie du tampon est pris à partir de la connexion du couple de transistors. On applique le signal d'entrée et une impulsion de précharge à la grille du transistor couplé au potentiel relativement négatif de l'alimentation. L'impulsion de précharge øpc se produit pendant une durée relativement courte, au début de chaque période de bit (noter qu'une période de bit pour une application d'affichage LCD correspond à un temps de ligne horizontale). Le niveau logique des données appliqué à l'entrée du signal de l'inverseur de tampon doit être déterminé avant la fin de l'impulsion de précharge. On se reporte à l'inverseur de tampon comprenant les transistors 142 et 143, et générant le signal logique Dn appliqué à la grille du transistor 144. Le complément de Dn, $\overline{Dn}$, fourni par exemple par un circuit de stockage (non dessiné), est appliqué à la grille du transistor 143. L'impulsion de précharge øpc est appliquée à la grille du transistor 142 et le signal logique Dn est disponible au noeud 196. Si le signal d'entrée, par exemple Dn, est un état logique de niveau bas, ce qui rend le transistor chuteur (143) non-passant, le transistor de charge (142) chargera le noeud de sortie (196) au potentiel d'alimentation positif $V_S$ pendant l'impulsion øpc. A la fin de l'impulsion de précharge, le transistor de charge (142) est rendu non-passant, le potentiel $V_S$ étant stocké par la capacité de dispersion (170) associée au noeud de sortie de l'inverseur de tampon.

Inversement, si le signal d'entrée ($\overline{Dn}$) est un niveau logique haut, le transistor chuteur (143) sera passant, ce qui empêchera toute accumulation de charge dans la capacité de dispersion (170) associée au noeud de sortie (196) de l'inverseur de tampon. Dans ce cas, peu après la fin de l'impulsion de charge, au moins, le potentiel du noeud de sortie (196) de l'inverseur sera un niveau logique bas. Que $\overline{Dn}$ soit un niveau logique haut ou bas, la valeur logique déterminée par la capacité 170 est conservée pendant la durée du mot porteur d'information, c'est-à-dire approximativement pendant la partie active du temps de ligne horizontale relatif à l'application d'affichage de type LCD.

Les inverseurs intermédiaires de précharge servent à appliquer les valeurs en bits de données aux transistors 144 et 148, afin que, quand un niveau logique haut est appliqué à leur grille respective (144, 148), l'impédance à la source de la valeur en bits de données soit extrêmement forte. Ceci permet une augmentation de la tension capacitive au niveau de la grille, comme il sera expliqué ci-après. En utilisant un inverseur de tampon de précharge dans lequel une charge est d'abord accumulée sur le noeud de sortie de l'inverseur, puis déchargée selon le niveau logique de la donnée appliquée, on évite de construire un inverseur avec des transistors proportionnés. Ainsi, on obtient un chuteur relativement rapide avec des transistors chuteurs relativement petits.

Si l'on considère les inverseurs intermédiaires en entrée qui comprennent les transistors (142,143) et (150,151), le potentiel relativement négatif de leur alimentation est, par hypothèse, celui de la masse. En ce qui concerne le tampon en sortie comprenant les transistors 152 et 149, le potentiel d'alimentation relativement négatif est nominalement celui de la masse, bien qu'il soit éventuellement préférable de l'établir à une amplitude légèrement inférieure à la tension d'enclenchement ou de seuil des transistors 145. La raison en est la suivante : au début d'un cycle de bit, le noeud de sortie 190 est préchargé au potentiel d'alimentation positif $V_S$. Ce potentiel est stocké par une capacité de dispersion 176 relativement petite. Si celle-ci est déchargée accidentellement, elle ne peut être rechargée (dans ce système) qu'au cycle de bit suivant. Par conséquent, il est impératif que le transistor chuteur 149 ne soit pas rendu conducteur accidentellement. Elever le niveau de potentiel appliqué à l'électrode de source du transistor 149 élève le niveau de potentiel applicable à sa grille avant qu'il ne soit mis en fonction. Ainsi, en appliquant le potentiel relativement plus positif $V_B$ à l'électrode de source du transistor 149, l'immunité du système contre le bruit est accrue. L'amplitude de l'alimentation $V_B$ est une valeur qui détermine le niveau bas du signal de sortie MO. Comme ce signal doit être capable de présenter la valeur logique de niveau bas, l'amplitude de $V_B$ doit être inférieure au maximum autorisé pour une valeur logique de niveau bas.

Le signal de sortie MO est préchargé au niveau logique "1", au début du cycle de bit, et est déchargé au niveau logique "0" au moment de la première impulsion positive au noeud 188. Ceci ne peut se produire qu'après le passage au niveau bas du signal d'entrée MI.

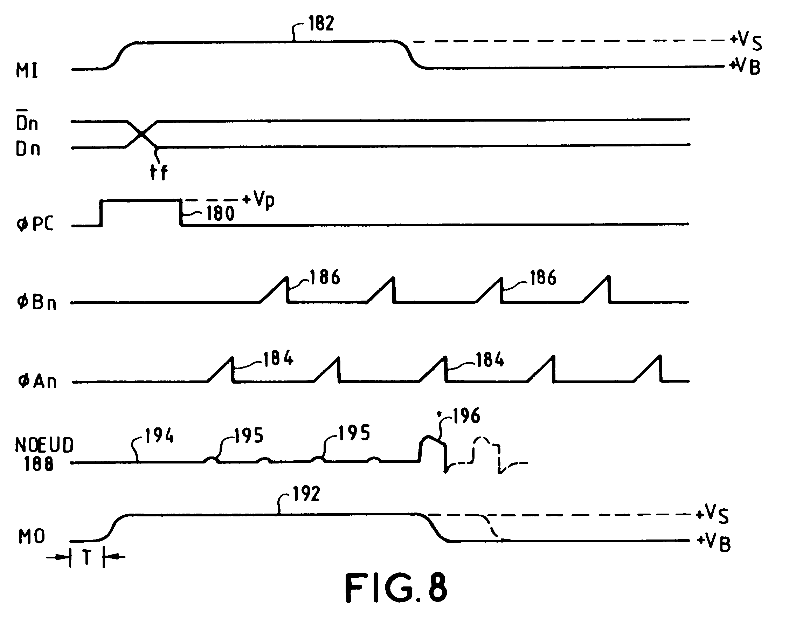

La synchronisation relative des composants du circuit présenté à la Figure 7 est illustré par les profils de la Figure 8.

En se référant à nouveau à la Figure 7, il est envisagé que tous les transistors de charge 142, 144, 148, 150 et 152 soient à enrichissement, et chargent donc leur noeud de sortie respectif dans un mode suiveur de source relativement lent. En ce qui concerne les inverseurs intermédiaires de précharge, ceci à peu d'impact car la précharge se produira normalement pendant les intervalles de suppression de lignes. Les intervalles de suppression fournissent en effet suffisamment de temps pour le chargement, même dans le cas de transistors de charge relativement petits et de faible mobilité.

Il n'en est pas de même pour le temps de chargement du noeud 188 par les transistors 144 ou 148. En premier lieu, la tension de commande appliquée aux grilles des transistors 144 et 148 n'est pas plus large que (øpc - $V_T$), øpc étant l'amplitude de l'impulsion d'horloge de précharge appliquée au transistor 142 ou 150, et $V_T$ étant la tension de seuil des transistors (éventuellement de l'ordre de plusieurs Volts). En second lieu, la durée disponible est limitée. Si l'on considère un intervalle de ligne active de 53 µs et des données à 8 bits, par exemple, la période de synchronisation des phases d'horloge øA8, øB8 est de 53/128 µs, soit 0,415 µs, ce qui représente une durée relativement courte pour charger le noeud 188.

La capacité de charge des transistors 144 et 148 est améliorée en augmentant la tension de commande des grilles. Considérons que le noeud 196 présente un "1" logique et que l'on désire charger le noeud 188 au moyen du transistor 144. Comme on le sait, plus le potentiel grille-source appliqué à un transistor est élevé, plus le courant qu'il conduira sera fort et, par conséquent, moins il faudra de temps pour la charge capacitive.

L'impédance au noeud 196 est principalement capacitive puisque les deux transistors 142 et 143 ne sont pas passants (si le noeud 196 présente un "1" logique). Soit une impulsion d'horloge positive øA appliquée à l'électrode de drain 155 du transistor 144, comme il existe un potentiel de "1" logique sur le transistor 144, le noeud 188 commencera à charger via le chemin conducteur drain-source. Il faut cependant noter qu'une partie de l'impulsion d'horloge øA appliquée à l'électrode de drain du transistor 144 se couplera à la grille de celui-ci via la capacité 158, ce qui améliore la tension de commande de cette grille et met le transistor en fonction plus forte. De plus, alors que le noeud 188 commence à charger, une partie de son potentiel est recouplée à la grille par l'intermédiaire de la capacité 160, obtenant ainsi une meilleure attaque de cette grille.

Les capacités 158, 160 et 170 sont conçues l'une par rapport à l'autre pour :

a) augmenter la tension de commande sur la grille du transistor 144 et améliorer son rendement lorsqu'un "1" logique est appliqué à sa porte,

b) assurer que le transistor 144 n'a pas été accidentellement mis en fonction par un couplage du potentiel d'horloge à sa grille, lorsque le transistor 143 fixe l'amplitude de la porte au niveau de la masse,

c) éviter qu'un potentiel d'horloge suffisant pour mettre accidentellement en fonction le transistor 149 ne soit couplé au noeud 188 par l'intermédiaire des capacités 158 et 160.

Les signaux d'horloge øA et øB sont reliés aux électrodes de drain des transistors 144 et 148 via les condensateurs 154 et 156, ceci afin de limiter le courant disponible pour charger la capacité associée au noeud 188. Cette limitation du courant de conduction permet d'utiliser un transistor chuteur 145 plus petit. Compte tenu du fait que le courant disponible des signaux d'horloge couplés capacitivement est proportionnel à Cdv/dt, il est avantageux de prolonger la transition de ces signaux. Ainsi, pour les étages montrés sur la Figure 7, on emploie des impulsions d'horloge possédant des bords inclinés, c'est-à-dire que ces signaux sont en dents de scie tels que montrés sur la Figure 8. Le couplage capacitif des tensions d'horloge exige l'utilisation de signaux d'horloge d'amplitude plus importante. Par conséquent, le potentiel à l'électrode de drain des transistors non-passants peut devenir excessif. Pour éviter une telle situation, les transistors 146, 147, protégés par une diode sont connectés entre leur électrode de drain respective et un point de potentiel de verrouillage. Ce potentiel est un potentiel de seuil situé en-dessous du niveau de tension désiré.

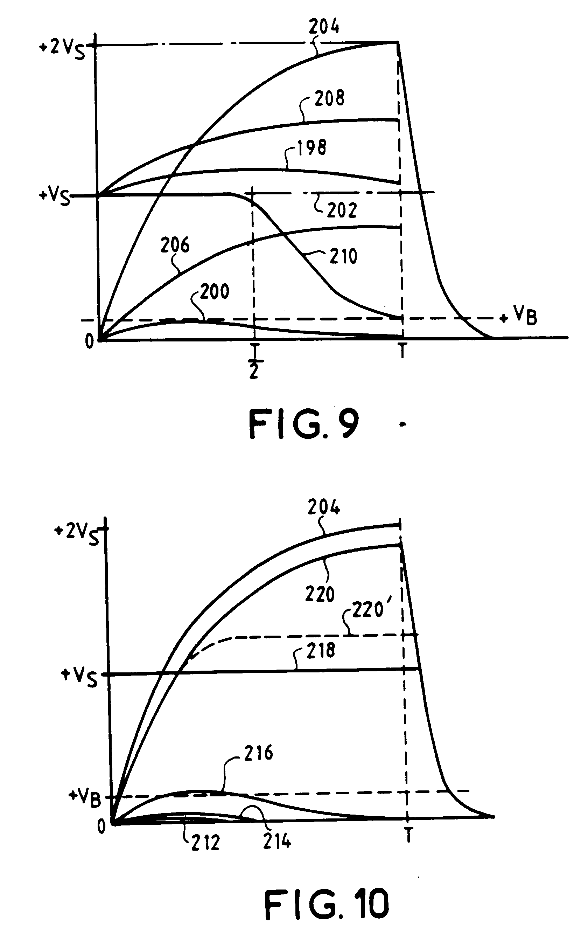

La Figure 9 représente plusieurs profils de signaux correspondant à un étage 140 à un seul bit avec un transistor 143 non-passant. Le noeud 196 a un certain niveau de tension pendant une période T, comme l'indique la courbe 198. Comme le noeud 196 se trouve statistiquement à environ $+V_S$, ou légèrement au-dessus, le transistor 144 deviendra passant. Il faut noter que la courbe 198 est représentative de la tension au noeud 196 aux moments où $\overline{D}_n$ est "en bas", et où le signal d'entrée de démarrage ou MI est "en haut". De même, dans ce cas, la courbe 200 montre les petites impulsions de tension 195 au noeud 188, la courbe 202 la tension $(+V_S)$ au noeud 190, et le profil 204 représente un signal d'horloge, qu'il s'agisse de øAn ou de øBn. Si le signal MI passe "en bas" alors que l'état des autres signaux reste le même, le noeud 188 subira une transition de tension, comme indiqué par la courbe 206, et le noeud 196 présentera la tension figurée par la courbe 208, lorsque le signal de commande øAn ou øBn est appliqué à l'étage compteur 140, sous la forme du signal d'horloge 204. La courbe 210 illustre la décharge du noeud 190 lorsque le noeud 188 passe au niveau haut. En pratique, des simulations informatiques ont montré que le noeud 190 ne se déchargeait pas de manière sensible avant qu'environ T/2 ne se soit écoulé (cf. Figure 9 pour le profil 210). Cette caractéristique peut améliorer la synchronisation dans le cas de multiples étages en cascade.

Dans la Figure 9, si le signal MI est "en haut" au moment où øAn ou øBn se produit, le transistor 145 reste passant, et le noeud 188 ne peut élever la tension que faiblement (comme indiqué par la courbe 200) et ce, même si le transistor 144 reste passant, ceci étant dû à l'effet de l'action d'amorçage fournie par la capacité interélectrode 158, L'élévation de tension au noeud 188, à cet instant (signal 200), est insuffisant pour commuter le transistor 149, sauf si cette augmentation dépasse le total de la tension de seuil et la tension de référence $(V_{TH} + V_B)$. Par conséquent, une tension impulsionnelle simple 200 au noeud 188, à cet instant, ne peut pas provoquer la décharge du noeud 190. Plusieurs de ces impulsions approchant le seuil peuvent cependant se cumuler et se traduire par une décharge non négligeable, sur un long intervalle de temps tel que 50 ils après la fin de l'impulsion de précharge 180. Pour éviter une décharge intempestive de ce type, il a été établi expérimentalement que l'amplitude maximale d'impulsion 195 (signal 200) doit se situer autour de 3 Volts sous le seuil de tension $V_{TH}$ du transistor 149. Ainsi, si la tension de seuil du transistor 149 est 3.0 V, la tension $+V_B$ doit être égale à la tension maximale d'impulsion qui pourrait se présenter au noeud 188. Dans la pratique, une tension d'impulsion 200 de 2.0 V est normalement employée.

A l'étage 140 de la Figure 7, considérons que le bit de donnée $D_n$ est "bas" et que $\overline{Dn}$ est "haut", donc le transistor 143 est passant. La Figure 10 présente les profils de tension associés aux différents noeuds dans ce cas. La courbe 216 montre la tension au noeud 196 telle qu'elle est, que le signal MI soit "bas" ou "haut". La courbe 212 représente la très faible tension parasite au noeud 188 lorsque le signal MI est "haut". La courbe 214 montre une tension plutôt large à ce même noeud lorsque le signal MI est "bas". La courbe 218 représente la tension au noeud 190 en indiquant que le signal MO reste à +$V_S$ (tension au noeud 190), alors que la courbe 220 montre qu'une oscillation relativement importante de la tension se produit au noeud 155 ; cette tension 220 peut cependant approcher la courbe 204 en amplitude puisque l'appareil 144 est alors non-passant. Cette forte oscillation de la tension peut avoir tendance à "enclencher" 144 par l'intermédiaire d'un couplage via le condensateur 158. Pour éviter ceci, les transistors de verrouillage 146 et 147 sont prévus pour limiter l'amplitude de la courbe 220 par rapport à la courbe 204.

Avec un transistor de canal 143 passant et l'autre transistor de canal 151 non-passant, ou inversement, une impulsion au noeud 188 atteindra un niveau insignifiant si les transistors respectifs 144 et 148 restent non-passants pendant l'impulsion d'horloge du canal 204 correspondante, øAn or øBn. En considérant que c'est le cas, les transistors 143 et 151 doivent être prévus suffisamment larges, du point de vue du dispositif, pour conserver la tension au noeud correspondant (196 ou 222) à un niveau inférieur à une tension de seuil de transistor au-dessus de la tension apparaissant au noeud 188, pendant la durée de l'impulsion 204, qu'il s'agisse de øAn ou de øBn. En pratique, si la période T (Figure 9 ou 10) est égale à 0,7 μs, il suffit que les transistors 143 et 151 aient chacun une largeur de canal w égale à 15 microns, si l'on considère que les transistors 144 et 148 ont chacun une largeur de canal w de 200 microns. Par conséquent, de cette manière, les petits appareils de commutation de données permettent de commander des appareils de commutation très larges. Cette caractéristique est considérée comme unique et propre aux étages 140 des circuits amorcés à noeud préchargé décrits ici.

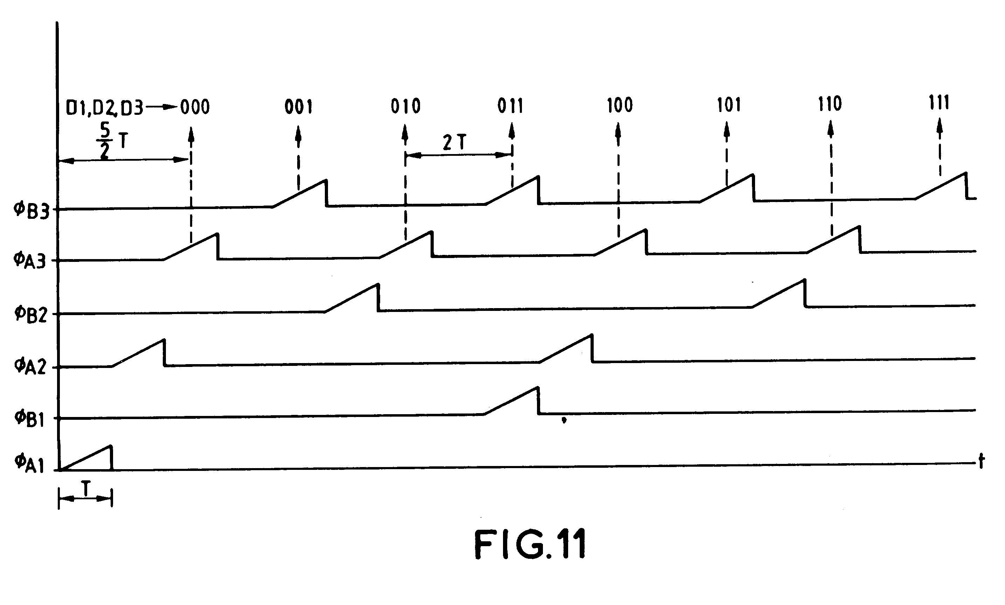

La Figure 11 montre un chronogramme typique pour un système comprenant trois étages à un bit 140 montés en cascade. Dans cet exemple, la durée des impulsions d'horloge øAn et øBn est supposée être T. On note que la période minimale d'impulsion 5T/2 se produit au front de l'impulsion de démarrage dans cette cascade de trois étages. On voit également que l'intervalle de sortie de données est de 2T pour le décodage de valeurs de données successives croissantes. La temporisation montée sur la Figure 11 permet une certaine marge de sécurité, c'est-à-dire qu'une synchronisation très précise des signaux n'est pas nécessaire. Ceci est dû au fait que le signal d'entrée MI d'un étage 140 donné passera en état bas à un temps T/2 avant que le signal d'horloge de cet étage ne se mette à monter, et T/2 après la fin du signal d'horloge de cet étage. Dans cette situation, un certain chevauchement des signaux d'horloge des étages successifs peut être admis.

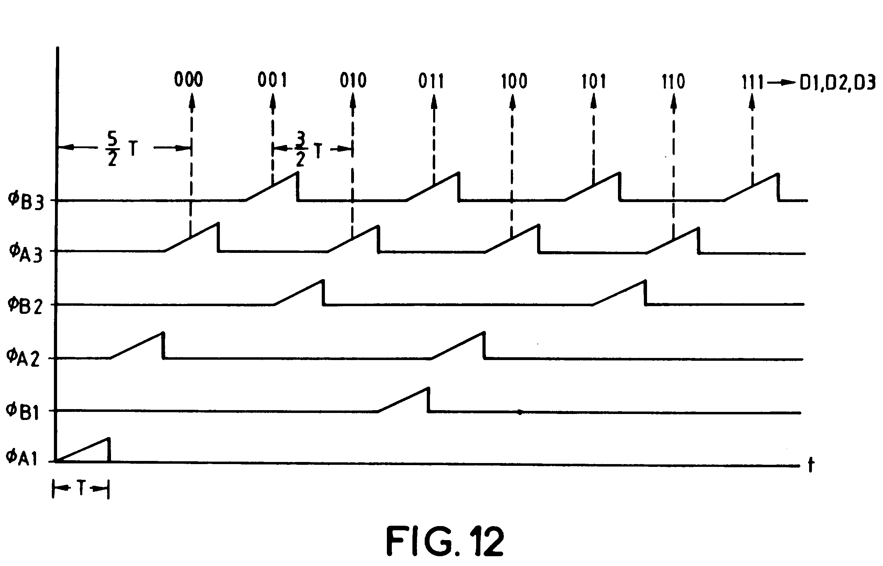

La Figure 12 montre un exemple de temporisation critique. Ici les données de sortie sont plus rapprochées (tout les 3T/2) et il n'existe plus de marge entre le point où le signal MI passe en état bas et la chute de l'impulsion d'horloge øBn pour un étage donné 140. Le délai de T/2 avant la montée de øAn est maintenu. On note également que pour un étage donné 140 le délai initial est 5T/2.

Les réalisations décrites ci-dessus sont données à titre d'illustration et ne sont pas limitatives. Des variantes et des modifications de ces réalisations - évidentes pour le spécialiste - ne s'écartent pas de l'étendue des revendications en annexe.

## Revendications

1. Appareil pour la génération d'impulsions de durée variable, comprenant :

   - une source fournissant une valeur binaire à n bits représentant la durée désirée des impulsions ;
   - un moyen (91) de génération de n couples de signaux d'horloge ØAn, ØBn (n = 1, 2, 3, etc.), chaque couple étant associé aux n bits de poids plus faible, et chaque couple successif comprenant un nombre supérieur d'impulsions par rapport au couple de numéro inférieur ;
   - n étages (90) numérotés séquentiellement et raccordés en cascade pour un fonctionnement pipeline et connectés de sorte que chaque étage active l'étage de numéro supérieur, chaque étage répondant à un bit de données Dn de ladite valeur binaire à n bits et aux signaux d'horloge ØAn, ØBn, passant l'un ou l'autre de ces signaux d'horloge selon que ledit bit de données est dans l'un ou l'autre de ces deux états.

2. Appareil selon la revendication 1, caractérisé en ce que le moyen (91) de génération de n couples de signaux d'horloge ØAn, ØBn (n = 1, 2, 3, etc.) présente des phases décalées l'une par rapport à l'autre et par rapport aux autres couples, et des cadences telles que la fréquence de chaque couple de signaux d'horloge est au moins le double de la fréquence du couple précédent.

3. Appareil selon la revendication 2, caractérisé en ce que les signaux ØAn et ØBn de chaque couple de signaux d'horloge ont une différence de phase de 180° l'un par rapport à l'autre.

4. Appareil selon l'une quelconque des revendications 1 à 3, caractérisé en ce que les n étages (90) sont des étages compteurs raccordés en cascade, chaque étage ayant des bornes d'entrée destinées à recevoir un couple de signaux d'horloge ØAn et ØBn, une borne d'entrée destinée à être reliée à ladite source destinée à recevoir un bit Dn de ladite valeur binaire à n bits, une borne d'entrée de démarrage, et une borne de sortie, la borne d'entrée de démarrage de chaque étage étant connectée à la borne de sortie de l'étage précédent, et la borne de sortie du dernier étage fournissant les impulsions requises ; chaque étage fournit une transition de l'un desdits signaux d'horloge ØAn, ØBn pour le bit Dn, et bascule entre deux états lors d'une transition à sa borne d'entrée.

5. Appareil selon l'une quelconque des revendications 1 à 4, caractérisé en ce que lesdits étages comprennent en plus un moyen de précharge, activé par un signal de précharge, pour initialiser l'état de la sortie de l'étage.

6. Appareil selon la revendication 5, caractérisé en ce que le moyen de précharge comprend :

   - une capacité connectée entre ladite borne de sortie et un point de potentiel sensiblement constant ;
   - un transistor dont la liaison conductrice principale est reliée entre ladite borne de sortie et un point de tension d'alimentation prédéterminée, et une électrode de contrôle reliée audit signal de précharge.

7. Appareil selon la revendication 5, caractérisé en ce que ledit moyen de précharge comprend un circuit bistable répondant audit signal de précharge afin d'initialiser ladite borne de sortie à un premier état, et répondant à une transition de l'un desdits signaux afin d'initialiser ladite borne de sortie à un second état.

8. Appareil selon la revendication 1, caractérisé en ce que chacun desdits étages comprend :

   - un premier moyen logique connecté audits signaux d'horloge ØAn, ØBn et ledit bit de données fournissant à la borne de l'étage un signal selon la relation booléenne :

     $$(\text{Ø}An \cdot Dn) + (\text{Ø}Bn \cdot Dn).$$

   - un second moyen logique répondant au signal provenant du premier moyen logique et un signal S appliqué à ladite borne de démarrage afin de fournir un signal selon la relation booléenne :

     $$S \cdot (((\text{Ø}An \cdot Dn) + (\text{Ø}Bn \cdot Dn)).$$

9. Appareil selon la revendication 6, caractérisé en ce qu'il inclut en plus :

   - un premier transistor ayant une liaison conductrice principale connectée entre ladite borne de sortie et un premier potentiel d'alimentation, et ayant une électrode de contrôle connectée audit second moyen logique ;
   - un second transistor ayant une liaison conductrice principale connectée entre ladite borne de sortie et un second potentiel d'alimentation, et ayant une électrode de contrôle connectée pour recevoir un signal de précharge afin d'initialiser ladite borne de sortie audit second potentiel au début de chaque impulsion de durée variable.

10. Appareil selon la revendication 1, caractérisé en ce que chacun des étages comprend :

    - des premier, second et troisième transistors chacun ayant une première, seconde et troisième électrode, les secondes électrodes du premier et second transistors étant connectées à la première électrode dudit troisième transistor, les seconde et troisième électrodes dudit troisième transistor étant connectées respectivement à un premier potentiel d'alimentation et à ladite borne d'entrée ;
    - des moyens respectifs de connexion des premières électrodes desdits premier et second transistors audits signaux d'horloge ;
    - un premier moyen de connexion dudit bit de données à l'électrode de contrôle dudit premier transistor ;
    - un second moyen pour connecter le complément dudit bit de données à l'électrode de contrôle dudit second transistor.

11. Appareil selon la revendication 8; caractérisé en ce que ledit premier moyen de connexion comprend un quatrième transistor ayant une liaison conductrice principale connectée entre l'électrode de contrôle dudit premier transistor et un second potentiel d'alimentation, et ayant une électrode de contrôle connectée pour recevoir un signal de précharge au début de chaque impulsion de durée variable, et en ce que ledit second moyen de connexion comprend un cinquième transistor ayant une liaison conductrice principale connectée entre l'électrode de contrôle dudit second transistor et ledit second potentiel d'alimentation et ayant une électrode de contrôle connectée pour recevoir un signal de précharge au début de chaque impulsion de durée variable.

12. Appareil selon la revendication 8, caractérisé en ce qu'il inclut un plus :

    - un quatrième transistor ayant une électrode de contrôle connectée aux secondes électrodes desdits premier et second transistors et une liaison conductrice principale connectée entre ladite borne de sortie et un troisième potentiel d'alimentation et ayant une électrode de contrôle connectée pour recevoir un signal de précharge ;
    - un cinquième transistor ayant une liaison conductrice principale connectée entre ladite borne de sortie et un second potentiel d'alimentation, et ayant une électrode de contrôle connectée pour recevoir un signal de précharge.

## Patentansprüche

1. Vorrichtung zur Erzeugung von Impulsen mit veränderlicher Dauer, mit folgenden:

   - einer einen Binärwert mit n Bit, der die gewünschte Impulsdauer darstellt, liefernden Quelle;
   - einem Mittel (91) zur Erzeugung von n Paaren von Taktsignalen øAn, øBn (n = 1, 2, 3 usw.), wobei jedes Paar mit den n niedrigstwertigen Bit verbunden ist und jedes nachfolgende Paar eine höhere Anzahl von Impulsen im Verhältnis zu dem Paar mit niedrigerer Zahl umfaßt;
   - n sequenziell numerierten und für eine Pipelinefunktion in Kaskade geschalteten Stufen (90), die so verbunden sind, daß jede Stufe die Stufe mit höherer Zahl aktiviert, wobei jede Stufe auf ein Datenbit Dn des besagten Binärwertes mit n Bit und auf die Taktsignale øAn, øBn reagiert, indem sie das eine oder das andere dieser Taktsignale durchläßt, je nachdem, ob das besagte Datenbit auf dem einen oder dem anderen dieser zwei Zustände liegt.

2. Vorrichtung nach Anspruch 1, dadurch gekennzeichnet, daß das Mittel (91) zur Erzeugung von n Paaren von Taktsignalen øAn, øBn (n = 1, 2, 3 usw.) Phasen, die in bezug aufeinander und in bezug auf die anderen Paare versetzt sind, und solche Taktfolgen, daß die Frequenz jedes Paars von Taktsignalen mindestens das Doppelte der Frequenz des vorhergehenden Paares ist, bietet.

3. Vorrichtung nach Anspruch 2, dadurch gekennzeichnet, daß die Signale øAn und øBn jedes Paars von Taktsignalen in bezug aufeinander einen Phasenunterschied von 180° aufweisen.

4. Vorrichtung nach einem der Ansprüche 1 bis 3, dadurch gekennzeichnet, daß die n Stufen (90) in Kaskade geschaltete Zählerstufen sind, wobei jede Stufe Eingangsanschlüsse zum Empfangen eines Paars von Taktsignalen øAn und øBn, einen Eingangsanschluß zur Verbindung mit der besagten Quelle zum Empfangen eines Bits Dn des besagten Binärwertes mit n Bit, einen Starteingangsanschluß und einen Ausgangsanschluß aufweist, wobei der Starteingangsanschluß jeder Stufe mit dem Ausgangsanschluß der vorhergehenden Stufe verbunden ist und der Ausgangsanschluß der letzten Stufe die erforderlichen Impulse liefert; wobei jede Stufe einen Übergang des einen der besagten Taktsignale øAn, øBn für das Bit Dn liefert und beim Vorhandensein eines Übergangs an ihrem Eingangsanschluß zwischen zwei Zuständen umschaltet.

5. Vorrichtung nach einem der Ansprüche 1 bis 4, dadurch gekennzeichnet, daß die besagten Stufen darüber hinaus ein Vorlademittel umfassen, das von einem Vorladesignal aktiviert wird, um den Zustand des Stufenausgangs zu initialisieren.

6. Vorrichtung nach Anspruch 5, dadurch gekennzeichnet, daß das Vorlademittel folgendes umfaßt:

   - eine zwischen den besagten Ausgangsanschluß und einen Punkt mit im wesentlichen konstantem Potential geschaltete Kapazität;
   - einen Transistor, dessen Hauptleitverbindung zwischen den besagten Ausgangsanschluß und einem Punkt vorbestimmter Speisespannung geschaltet ist, und bei dem eine Steuerelektrode mit dem besagten Vorladesignal verbunden ist.

7. Vorrichtung nach Anspruch 5, dadurch gekennzeichnet, daß das besagte Vorlademittel eine bistabile Schaltung umfaßt, die auf das besagte Vorladesignal reagiert, um den besagten Ausgangsanschluß auf einen ersten Zustand zu initialisieren, und auf einen Übergang des einen der besagten Signale reagiert, um den besagten Ausgangsanschluß auf einen zweiten Zustand zu initialisieren.

8. Vorrichtung nach Anspruch 1, dadurch gekennzeichnet, daß jede der besagten Stufen folgendes umfaßt:

   - ein erstes mit den besagten Taktsignalen øAn, øBn verbundenes Logikmittel, wobei das besagte Datenbit dem Anschluß der Stufe ein Signal nach folgendem Boolschen Verhältnis zuführt:

     (øAn . Dn) + (øBn . Dn),

   - ein zweites Logikmittel, das auf das vom ersten Logikmittel kommende Signal und ein an den besagten Startanschluß angelegtes Signal S reagiert, um ein Signal nach folgendem Boolschen Verhältnis zu liefern:

     S. (((øAn . Dn) + (øBn . Dn)).

9. Vorrichtung nach Anspruch 6, dadurch gekennzeichnet, daß sie darüber hinaus folgendes enthält:

   - einen ersten Transistor mit einer Hauptleitverbindung, die zwischen den besagten Ausgangsanschluß und ein erstes Speisepotential geschaltet ist, und mit einer an das zweite Logikmittel angeschalteten Steuerelektrode;

- einen zweiten Transistor mit einer Hauptleitverbindung, die zwischen den besagten Ausgangsanschluß und ein zweites Speisepotential geschaltet ist, und mit einer zum Empfangen eines Vorladesignals geschalteten Steuerelektrode zum Initialisieren des besagten Ausgangsanschlusses auf das besagte zweite Potential zu Beginn jedes Impulses mit veränderlicher Dauer.

10. Vorrichtung nach Anspruch 1, dadurch gekennzeichnet, daß jede der Stufen folgendes umfaßt:

- einen ersten, zweiten und dritten Transistor mit ie einer ersten, zweiten und dritten Elektrode, wobei die zweiten Elektroden des ersten und zweiten Transistors mit der ersten Elektrode des besagten dritten Transistors verbunden sind, wobei die zweite und dritte Elektrode des besagten dritten Transistors jeweils mit einem ersten Speisepotential und dem besagten Eingangsanschluß verbunden sind;
- entsprechende Mittel zur Verbindung der ersten Elektroden des besagten ersten und besagten zweiten Transistors mit den besagten Taktsignalen;
- ein erstes Mittel zur Verbindung des besagten Datenbits mit der Steuerelektrode des besagten ersten Transistors;
- ein zweites Mittel zum Verbinden des besagten Komplements des besagten Datenbits mit der Steuerelektrode des besagten zweiten Transistors.

11. Vorrichtung nach Anspruch 8, dadurch gekennzeichnet, daß das besagte erste Mittel zur Verbindung einen vierten Transistor mit einer Hauptleitverbindung, die zwischen die Steuerelektrode des besagten ersten Transistors und ein zweites Speisepotential geschaltet ist, und mit einer Steuerelektrode, die zum Empfangen eines Vorladesignals zu Beginn jedes Impulses mit veränderlicher Dauer geschaltet ist, umfaßt, und daß das besagte zweite Mittel zur Verbindung einen fünften Transistor mit einer Hauptleitverbindung, die zwischen die Steuerelektrode des besagten zweiten Transistors und das besagte zweite Speisepotential geschaltet ist, und mit einer Steuerelektrode, die zum Empfangen eines Vorladesignals zu Beginn jedes Impulses mit veränderlicher Dauer geschaltet ist, umfaßt.

12. Vorrichtung nach Anspruch 8, dadurch gekennzeichnet, daß sie darüber hinaus folgendes enthält:

- einen vierten Transistor mit einer Steuerelektrode, die mit den zweiten Elektroden des besagten ersten und zweiten Transistors verbunden ist, und einer Hauptleitverbindung, die zwischen den besagten Ausgangsanschluß und ein drittes Speisepotential geschaltet ist, und mit einer Steuerelektrode, die zum Empfangen eines Vorladesignals geschaltet ist;

- einen fünften Transistor mit einer Hauptleitverbindung, die zwischen den besagten Ausgangsanschluß und ein zweites Speisepotential geschaltet ist, und mit einer Steuerelektrode, die zum Empfangen eines Vorladesignals geschaltet ist.

## Claims

1. Apparatus for generating variable-duration pulses, comprising:

- a source supplying an n-bit binary value representing the desired duration of the pulses;
- a means (91) of generating n pairs of clock signals ØAn, ØBn (n = 1, 2, 3 etc.), each pair being associated with the n least significant bits, and each successive pair comprising a higher number of pulses with respect to the lower-numbered pair;
- n stages (90) numbered sequentially and connected in cascade for pipeline operation and connected in such a way that each stage activates the higher-numbered stage, each stage responding to one data bit Dn of the said n-bit binary value and to the clock signals ØAn, ØBn, passing one or other of these clock signals according to whether the said data bit is in one or the other of its two states.

2. Apparatus according to Claim 1, characterized in that the means (91) of generating n pairs of clock signals ØAn, ØBn (n = 1, 2, 3, etc.) has phases shifted with respect to one another and with respect to the other pairs, and rates such that the frequency of each pair of clock signals is at least twice the frequency of the preceding pair.

3. Apparatus according to Claim 2, characterized in that the signals ØAn and ØBn of each pair of clock signals have a phase difference of 180° with respect to one another.

4. Apparatus according to any one of Claims 1 to 3, characterized in that the n stages (90) are counter stages connected in cascade, each stage having input terminals intended to receive a pair of clock signals ØAn and ØBn, an input terminal intended to be connected to the said source intended to receive one bit Dn of the said n-bit binary value, a trigger input terminal, and an output terminal, the trigger input terminal of each stage being connected to the output terminal of the preceding stage, and the output terminal of the last stage supplying the required pulses; each stage supplies a transition of one of the said clock signals ØAn, ØBn for the bit Dn, and toggles between two states upon a transition at its input terminal.

5. Apparatus according to any one of Claims 1 to 4, characterized in that the said stages additionally comprise a precharging means, activated by a precharging signal, to initialize the state of the output of the stage.

6. Apparatus according to Claim 5, characterized in that the precharging means comprises:

   - a capacitance connected between the said output terminal and a point of substantially constant potential;
   - a transistor the principal conducting link of which is connected between the said output terminal and a predetermined power supply voltage point, and a control electrode linked to the said precharging signal.

7. Apparatus according to Claim 5, characterized in that the said precharging means comprises a bistable circuit responding to the said precharging signal so as to initialize the said output terminal to a first state, and responding to a transition of one of the said signals so as to initialize the said output terminal to a second state.

8. Apparatus according to Claim 1, characterized in that each of the said stages comprises:

   - a first logic means connected to the said clock signals ØAn, ØBn and the said data bit supplying the terminal of the stage with a signal according to the boolean relationship:

   $$(ØAn \cdot Dn) + (ØBn \cdot Dn).$$

   - a second logic means responding to the signal originating from the first logic means and a signal S applied to the said trigger terminal so as to supply a signal according to the boolean relationship:

   $$S.(((ØAn \cdot Dn) + (ØBn \cdot Dn)).$$

9. Apparatus according to Claim 6, characterized in that it further includes:

   - a first transistor having a main-conducting link connected between the said output terminal and a first power supply terminal, and having a control electrode connected to the said second logic means;
   - a second transistor having a main conducting link connected between the said output terminal and a second power supply terminal, and having a control electrode connected in order to receive a precharging signal so as to initialize the said output terminal to the said second potential at the start of each variable-duration pulse.

10. Apparatus according to Claim 1, characterized in that each of the stages comprises:

    - first, second and third transistors each having a first, second and third electrode, the second electrodes of the first and second transistors being connected to the first electrode of the said third transistor, the second and third electrodes of the said third transistor being connected respectively to a first power supply potential and to the said input terminal;
    - respective means of connecting the first electrodes of the said first and second transistors to the said clock signals;
    - a first means of connecting the said data bit to the control electrode of the said first transistor;
    - a second means of connecting the complement of the said data bit to the control electrode of the said second transistor.

11. Apparatus according to Claim 8; characterized in that the said first connection means comprises a fourth transistor having a main conducting link connected between the control electrode of the said first transistor and a second power supply potential, and having a control electrode connected in order to receive a precharging signal at the start of each variable-duration 5 pulse, and in that the said second connection means comprises a fifth transistor having a main conducting link connected between the control electrode of the second transistor and the said second power supply potential and having a control electrode connected in order to receive a precharging signal at the start of each variable-duration pulse.

12. Apparatus according to Claim 8, characterized in that it further includes:

    - a fourth transistor having a control electrode connected to the second electrodes of the said first and second transistors and a main conducting link connected between the said output terminal and a third power supply potential and having a control electrode connected in order to receive a precharging signal;
    - a fifth transistor having a main conducting link connected between the said output terminal and a second power supply potential, and having a control electrode connected in order to receive a precharging signal.

# FIG.1 ·

# FIG. 2

FIG.3

FIG. 4

FIG. 5

FIG. 6

FIG.7

FIG.8

EP 0 513 330 B1

FIG. 9

FIG. 10

FIG.11

EP 0 513 330 B1

FIG. 12